# EUROPEAN PATENT SPECIFICATION

(11) **EP 4 175 079 B1**
(45) Date of publication and mention of the grant of the patent: **10.09.2025**
(21) Application number: 22461628.4
(22) Date of filing: 30.10.2022
(51) Int. Cl.: H01S 5/12, H01L 21/3063, G02B 5/18

(54) **METHOD OF FABRICATION OF REGION WITH REGULARY VARYING REFRACTIVE INDEX IN A LAYERED SEMICONDUCTOR STRUCTURE**
VERFAHREN ZUR HERSTELLUNG EINER REGION MIT REGELMÄSSIG VERÄNDERNDER BRECHUNGSINDEX IN EINER GESCHICHTETEN HALBLEITERSTRUKTUR
PROCEDE DE FABRICATION D'UNE REGION A INDICE DE REFRACTION VARIABLE REGULIER DANS UNE STRUCTURE A SEMI-CONDUCTEUR EN COUCHES

(30) Priority: 30.10.2021 PL 43936821
(43) Date of publication of application: 03.05.2023
(73) Proprietor: Instytut Wysokich Cisnien Polskiej Akademii Nauk, 01-142 Warszawa (PL)
(72) Inventor: SAWICKA, Marta, 02-866 Warszawa (PL); MUZIOL, Grzegorz, 01-466 Warszawa (PL); FIUCZEK, Natalia, 02-414 Warszawa (PL); HAJDEL, Mateusz, 81-173 Gdynia (PL); SKIERBISZEWSKI, Czeslaw, 05-502 Kamionka (PL)
(74) Representative: AOMB Polska Sp. z.o.o.

(56) References cited:
- WO-A1-2021/150304
- CA-A1- 2 254 275
- GB-A- 2 079 536
- US-A1- 2020 033 530

## Description

The present invention relates to a method of fabrication of a region with a regularly variable refractive index in a selected layer of a layered semiconductor structure fabricated epitaxially of group-III nitrides on a crystalline substrate.

The embedded layers with a regularly variable refractive index, which are located inside the semiconductor structure, are known in the technology of fabrication of some semiconductor optoelectronic devices, for example laser diodes. Most often, for the purpose of obtaining such a volume, a mask is fabricated by the lithography method on a selected semiconductor layer, and subsequently dry etching method is used to make grooves or openings in said layer, and subsequently another layer of a material with a different refractive index than that of the material of the layer with the grooves is applied. Thus fabricated periodic photonic structure is integrated monolithically, epitaxially with the device structure. Fabrication of such photonic structures inside optoelectronic devices is disclosed in EP1094345A1. The possibility to implement this concept in nitrides of group III metals is presented for example in the paper by D.Hofstetter, RL Thornton, LT Romano, DP Bour, M. Kneissl & RM Donaldson titled "Roomtemperature pulsed operation of an electrically injected InGaN/GaN multi-quantum well distributed feedback laser" [Applied Physics Letters 73, 2158-2160 (1998)]. It describes a diffraction grating located inside the structure and integrated monolithically with said structure. Unfortunately, such a solution cannot be used routinely in group-III nitrides for the fabrication of photonic elements inside the structures based on group-III nitrides, because gallium nitride (GaN) and its alloys with indium and aluminium are characterised by a low contrast of the refractive index and a large lattice mismatch. These two features constitute a fundamental obstacle in fabrication of a high quality of buried photonic structures unlike in the case of group III arsenides and group III phosphides. Therefore, photonic gratings in devices based on group III nitrides are usually formed on the top surface. Another advantage of placing a diffraction grating on the top surface is that the contrast between GaN and air is much higher than between GaN and its alloys with indium or aluminium. For example, the refractive index for the wavelength of 450 nm is 2.45 for GaN, 2.40 for AlGaN with 8% Al content, and 1 for air. Examples of devices with a photonic grating on the surface are disclosed in EP3767762A1, US6671306B1, US4722092A and US4777148A. A different approach to fabrication of a diffraction grating embedded inside a semiconductor structure is presented in the example of a structure based on group arsenides in US6365428B1, which discloses the use of lateral oxidation of components of the diffraction grating placed inside the structure, which components were made previously in the process of lithography of an appropriate pattern, dry etching and re-epitaxy. Exposure of the AlAs layer side surface and its lateral oxidation causes a considerable increase in the refractive index contrast between the materials forming the diffraction grating. A similar solution is disclosed in US6649439B1, which presents a method of periodic distribution of a dielectric inside the structure obtained in the re-growth process. A further increase in the contrast between the materials forming the diffraction grating is possible through selective removal of the dielectric layer, which leads to obtaining empty spaces. Both solutions described above are applied in devices based on group III arsenides and group III phosphides. A similar demonstration in the material system of group III nitrides is presented in the paper by H. Matsubara, S. Yoshimoto, H. Saito, Y. Jianglin, Y. Tanaka, and S. Noda titled "GaN Photonic-Crystal Surface-Emitting Laser at Blue-Violet Wavelengths" [Science 319, 445-447 (2008)]. It discloses a network of openings formed with the use of electron-beam lithography. A dielectric layer, which blocks the further epitaxial growth, is applied to the lower surface of such an opening. Using the anisotropy of the vertical and lateral growth rates of GaN, the openings were overgrown in the re-growth process to form an ordered network of empty spaces filled with air and the remaining dielectric layer. However, this approach poses a risk of defects at the place of coalescence of the opening edges during the overgrowth. A change in the electric properties of semiconductors through ion implantation is well known. An example of a detailed description of implantation doping of GaN is presented in US9984881 B2 . In this document, selective area doping is applied to fabricate an ohmic contact. Selected areas are masked before ion implantation. Obtaining desired change in electric properties, namely n-type conductivity, using implantation doping of group III nitrides requires thermal activation, often after appropriate covering the surface to prevent its decomposition. It is proved that n-type doping of GaN is possible with the use of Si or Ge ion implantation and subsequent high temperature annealing. In addition, selective removal of an epitaxial n-type doped layer through electrochemical etching of group III nitrides is known. A method of selective removal of certain n-type conductivity layers of GaN with a higher concentration of dopants than in the other GaN layers in the same structure is disclosed for example in US10458038B2. The use of said technology for fabricating optoelectronic devices is disclosed for example in US20170133826A1, which presents, among others, fabrication of openings that give the electrolyte access to the layers which are to be subject to lateral selective etching. However, this publication lacks any information about the possibility to apply this technology for fabricating air channels located at a regular spacing in a plane that is parallel to the substrate used for epitaxial growth, for the purpose of introducing a regularly and periodically variable refractive index in an n-type conductivity layer. Document WO2021150304A1 discloses stacked high contrast gratings (S-HCGs) containing grating layers composed of high refractive index III-nitride bars and low refractive index air and/or porous III-nitride bars. Further disclosed are methods for preparing and using such S-HCGs, for example, as bottom mirrors in vertical cavity surface emitting lasers (VCSELs). However, this publication discloses etching away the non-ion implanted regions of highly n-type doped nitride layers under EC etching conditions.

The goal of the invention is providing an effective method of fabrication of a volume with a regularly and strongly variable refractive index in a plane that is parallel to the substrate, in a selected layer of the layered semiconductor structure. This goal is achieved by the method according to the invention, as defined in claim 1, wherein after fabricating a selected epitaxial layer the growth process is interrupted and a mask that locally blocks the ion implantation is placed on the top surface of the fabricated structure. Said mask contains an array of longitudinal windows with the same width, which are parallel to each other and distributed at an equal spacing. Subsequently, the upper epitaxial layer is subjected to the ion implantation process to the depth that is not greater than the thickness of the upper epitaxial layer and to the concentration of the implanted atoms that is higher than 5 × 10¹⁸ cm-3. After the end of the ion implantation the mask is removed and the epitaxial growth of the structure is finished. Afterwards at least one groove for the etching medium is made in the protected external surface of said structure, with the groove reaching inside the structure at least up to a half of the thickness of the volumes that were subjected to the ion implantation. The material is removed by electrochemical etching with an acidic etching medium applied to the inside of the structure through said groove. The invention is characterized in that the upper epitaxial layer is subjected to the ion implantation process with the use of germanium or silicon ions. Subsequently, after the mask (3) is removed, the epitaxial growth of the structure is finished with a GaN layer providing a flat upper surface of the region. In the subsequent step, the epitaxial structure is annealed at a temperature from 1000 to 1400°C, for a period between ten seconds and one hour. After annealing said structure, its upper surface is covered to protect from the access of the etching medium to the top surface. Subsequently, the material that was subjected to the ion implantation is removed by electrochemical etching.

Preferred embodiments of the invention are defined in the dependent claims.

In one of the preferred embodiments of the invention, the mask is made in the process of electron-beam lithography or photolithography.

In another preferred embodiment of the invention, the width of the windows in the mask ranges from 25 to 1750 nm, while the sum of the window width and a spacing between the window edges ranges from 50 to 3000 nm.

In another preferred embodiment of the invention, oxalic acid and voltage ranging from 2 to 15 V are used for the electrochemical etching of the areas subject to the ion implantation.

In still another preferred embodiment of the invention, the etching of the volumes that were subjected to the ion implantation is carried out until the empty air channel spaces formed as a result of said etching are reached, with the length that is at least equal to the width of the mesa of the optoelectronic device in which the fabricated volume with a regularly variable refractive index will be used.

The invention breaks the commonly accepted opinion among specialists that a low refractive index contrast and the large lattice mismatch of nitride materials are fundamental obstacles in fabrication of photonic structures embedded inside the GaN based device structures. Importantly, a photonic element fabricated according to the invention does not use bulk materials such as GaN and AlGaN in the growth process, in which defects can be generated due to the different lattice constants, but for fabricating an ordered array of empty channel spaces a crystalline layer of GaN and air are used, thus eliminating the problem of lattice mismatch, at the same time ensuring a high contrast of the refractive indices. Unexpectedly, it has turned out that the application of a combination of already known techniques opens a door for fabricating periodic empty channel spaces inside the structure of optoelectronic instruments based on group-III nitrides. The placement of a layer with a periodically variable refractive index, being a one dimensional photonic element, inside the semiconductor structure made of group-III nitrides makes it possible to fabricate a new type of distributed feedback laser diodes (DFB LDs) structures. The invention makes it possible to obtain two dimensional photonic elements, such as networks of periodic openings or columns with the period in two in-plane directions, monolithically integrated in the structures of group III nitride devices, for example surface-emitting lasers. The application of the invention is possible also in other fields than optoelectronics, for example micro- or nanofluidics for fabricating a system of empty channels with an arbitrary layout in GaN, and for examining micro- and nanoflows. There are a few very important advantages of the invention, namely preservation of a flat upper surface for the subsequent epitaxial processes, a perfect epitaxial relation with the whole structure, and good electrical and thermal conductivity, which are of key importance in the structure of optoelectronic devices. Preservation of a flat surface above the empty air channels ensures a uniform thickness of the quantum wells grown epitaxially on top and facilitates applying metal contacts. The invention makes it possible to place an array of air channels under the group-III nitride structure surface, in a close proximity to the active region, less than 300 nm, which is necessary for ensuring a strong coupling of the diffraction grating with the optical mode of the optoelectronic device, for example in distributed feedback laser diodes. The invention can be applied both during the process of epitaxial growth of the device structure and after its end. It also provides a freedom of selection of the layout of the air channels geometry, depending on the applied implantation parameters and the selected mask fabrication technique, in particular giving the possibility to obtain periodicity of the refractive index ranging from 50 to 3500 nm. Fabrication of empty air channels through electrochemical etching is an uncomplicated and non-toxic process.

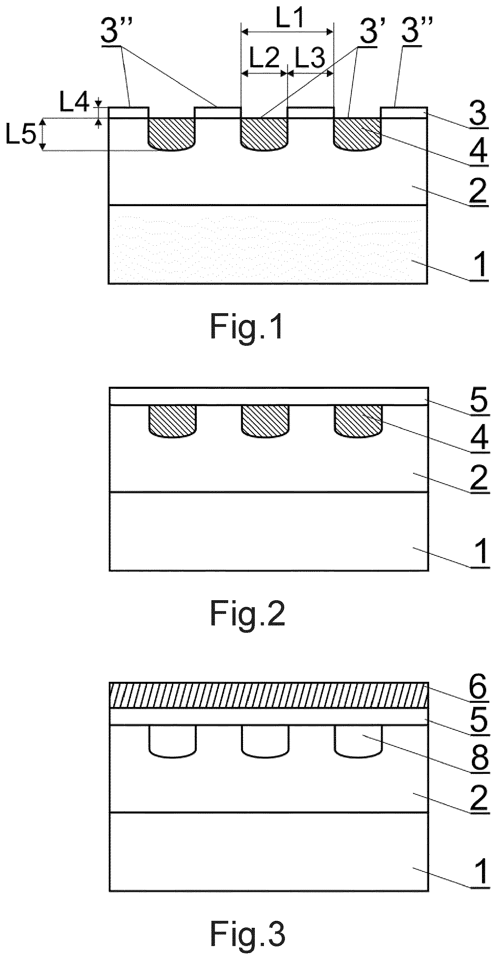

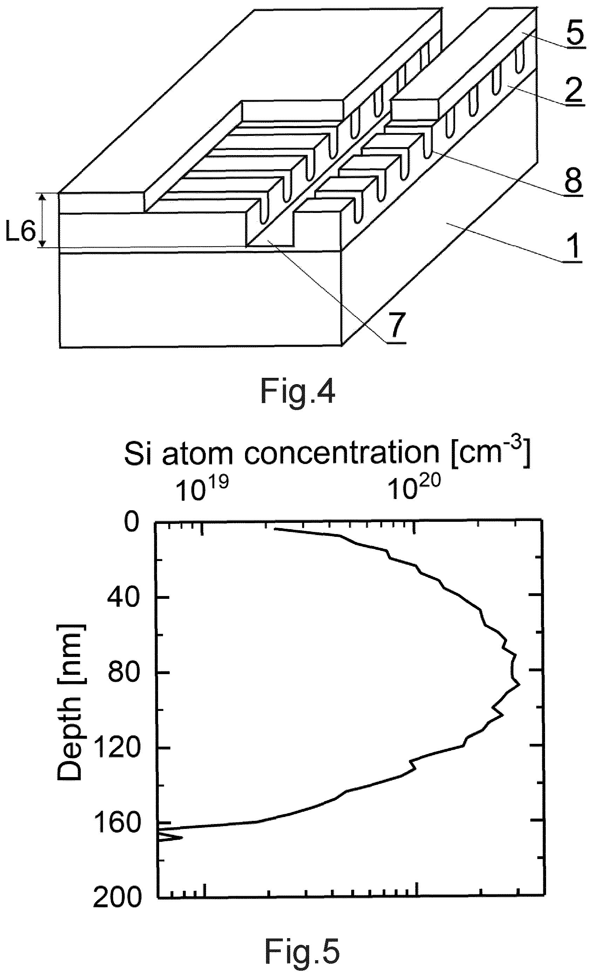

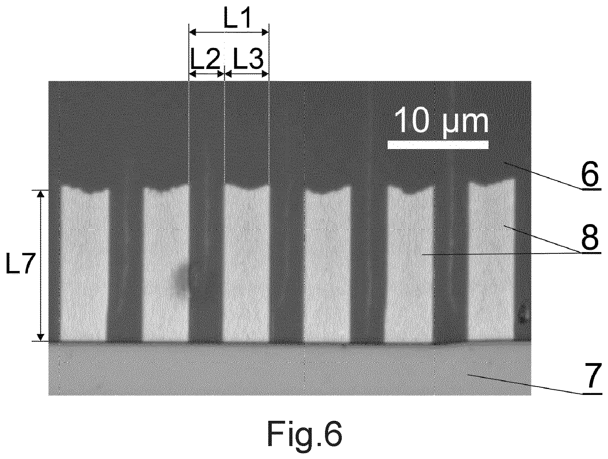

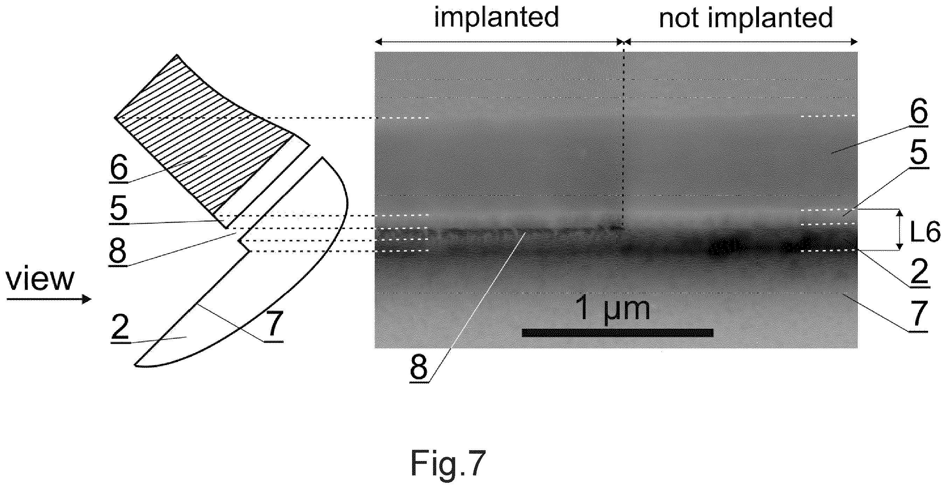

An embodiment of the invention is shown schematically in a drawing, with Fig.1 presenting a vertical profile of a nitride epitaxial structure after the mask fabrication and the ion implantation of selected areas, Fig.2 presenting the structure from Fig.1 after removing the mask and another epitaxial layer growth, and Fig.3 presenting the structure from Fig.2 after etching the areas that were subjected to the ion implantation. Fig.4 presents an axonometric view of the structure from Fig. 3 with the visible layout of the groove for the etching medium. Fig.5 presents a theoretically calculated profile of silicon ion implantation as a function of depth, which was applied in the embodiment. Fig.6 shows a top view of the surface of an embodiment of the epitaxial structure described below, after its electrochemical etching, imaged with the use of an optical microscope. Fig.7 presents a photograph taken by a scanning electron microscope of the vertical profile of the final nitride structure after the etching process reflected in a similar view as in Fig.3 , where the non-implanted place remained non-etched, while empty air channels fabricated in the etching process are visible at the positions which were previously subjected to the ion implantation.

The invention is presented in more detail in the embodiment, described below, of fabrication of an epitaxial substrate with a regularly variable refractive index in the first layer epitaxially grown on the crystalline substrate, on which another epitaxial layer is grown, which substrate is suitable (with appropriately decreased mask period), among others, for fabricating distributed feedback laser diodes. In order to fabricate said substrate, a GaN layer 2 with the thickness of 650 nm was applied to the gallium nitride crystalline substrate 1 in the process of plasma assisted molecular beam epitaxy (PAMBE). Instead of a non-intentionally doped layer 2, it is possible to apply a layer with a low n-type doping level, i.e. below 3 × 10¹⁸ cm-3 , to the substrate 1. Subsequently, a mask 3, intended to locally block the ion implantation, was made by photolithography according to a known method on the upper surface of the layer 2. The mask 3 contained an array of windows 3' with the width L2 of 4.5 µm, which were parallel to each other and separated from each other by implantation blocking mesas 3" with the width L3 of 3.5 µm. The sum of the widths L2 and L3 gives the periodicity L1 of the regions with a variable refractive index. The thickness L4 of the created mask 3 was 1.2 µm. After applying the mask 3, through the aforementioned windows 3', the ion implantation was performed according to a known method with the use of silicon ions with the energy of 100 keV with the dose of 2.6× 10¹⁵ cm-2 , to the depth L5 of 170 nm. As a result of said implantation, regions 4 containing implanted silicon atoms were obtained. A depth profile of the concentration of said atoms is reflected in the diagram in Fig.5 . Said diagram reveals that the maximum concentration of atoms in the volume of the regions 4 was 3 × 10²⁰ cm-3 at the depth of 76 nm. At the subsequent stage, the mask 3 was removed and a GaN layer 5 with the thickness of 100 nm was applied in the same epitaxial growth process as before, and subsequently the obtained layer structure was annealed for 5 minutes at the temperature of 1070°C. Before the annealing stage, in particular at a higher temperature than the example one, it is possible to apply, according to a known method, a protective layer which is not reflected in the drawing, made of for example silicon nitride, silicon oxide, aluminium nitride or a combination thereof, for the purpose of protecting the upper surface of the layer 5 from decomposition during the annealing. After the annealing stage, a covering layer 6 with the thickness of 500 nm made of silicon oxide SiOz was applied according to a known method for the purpose of blocking the access of the etching medium from the top, after which a groove 7 was made for the etching medium with the thickness L6 of 220 nm and the width of 5 µm. The groove 7 was made according to the known method of dry etching, i.e. through reactive ion etching in chlorine-argon plasma. After making the groove 7, electrochemical etching was carried out in a 0.3 mol oxalic acid solution with the voltage of 8 V and for the period of 120 minutes. The etching time can be chosen freely, in particular such that the length L7 (Fig.6 ) of the empty air channels 8 corresponds to the subsequent planned layout of the optoelectronic device fabricated on a substrate with a regularly variable refractive index, in particular such that the length L7 is greater than the width of the laser mesa. The control of the etching process of the regions 4 was carried out with the use of an optical microscope. Due to a strong change in the refractive index of the etched volume, a contrast was visible under the microscope at places where as a result of said etching the air channels 8 were formed. This is visible well in Fig.6 , where the lower surface of the groove 7 for the etching medium is visible. The empty air channel spaces 8 with the length L7, formed at the places of the previous ion implantation (4) during the 120 minutes of etching, start from the edge of the groove 7. The channel spaces 8 located under the surface of the epitaxial structure covered by a covering layer 6 from the top are visible in the top view as brighter ones due to the considerably reduced locally refractive index compared to the non-implanted and non-etched areas in the layer 2. The length L7 of the empty air channels 8 obtained after the aforementioned etching period of 120 minutes was estimated to be 15 µm on average based on the photographs from the optical microscope. Fig.7 presents an image of the structure after the electrochemical etching obtained with the use of a scanning electron microscope (SEM), after inclining it by 45 degrees, where the wall of the etching medium groove, containing the covering layer 6, the layer 5 and the layer 2, is visible in the central part. The profile counted from the upper surface of the layer 5 in the direction of the crystalline substrate 1 has the depth L6, which is 220 nm in the described embodiment. The image shown in Fig.7 proves that an empty air channel 8 is visible at the position which was previously subjected to silicon ion implantation (4), while the non-implanted areas remains unchanged. After the etching, it is possible to remove the covering layer 6 with the use of the known wet etching in a hydrofluoric acid solution. Fig.3 presents illustratively a schematic axonometric view of the structure with a system of periodically distributed air channels with the visible layout of an opening for the etching medium 7 after removing the covering layer 6. A part of the layer 5 is not shown illustratively in order to make the layout of the channels inside the structure visible. The invention can be implemented also where a different epitaxial technique is used for applying the layer 2 or in an example not in accordance with the claimed invention where the ion implantation is carried out directly to the GaN substrate. The mask 3 can be made also with the use of the known electron-beam lithography, which allows obtaining a shorter periodicity L1 providing a better coupling with the optical mode where the invention is applied for fabricating structures of distributed feedback laser diodes. In order to obtain channels 8, which will constitute a photonic element in a light emitter, the mask 3 is designed taking into account the wavelength of the final device. The optimum period L1 for lasers emitting light with the wavelength of 450 nm ranges from 50 to 3500 nm. The width L2 of the windows 3' in the mask 3 should range from 25 to 1750 nm. The surface of the windows 3' in the mask 3 for the electron-beam lithography or photolithography occupies between 5 and 60% of the whole surface of the mask 3. In order to make the mask by the electron-beam lithography method, also the mask thickness must be selected such that it locally blocks the ions being implanted. For example, a mask composed of a layer of silicon oxide SiOz with the thickness of 250 nm and a layer of chromium with the thickness of 20 nm effectively blocks silicon ions with the energy of 100 keV.

## Claims

1. A method of fabrication of a region with a regularly variable refractive index in a selected layer of a group-III nitride layered semiconductor structure fabricated epitaxially on a crystalline substrate (1), whereby after fabricating the selected epitaxial layer (2) the growth process is interrupted and a mask (3) that blocks an ion implantation locally is applied to the top surface of the fabricated structure (1, 2), wherein said mask (3) contains an array of longitudinal windows (3') each with the same width (L2), which are parallel to each other and distributed at an equal spacing (L3), and subsequently, the selected epitaxial layer which is the upper epitaxial layer (2) is subjected to an ion implantation process to a depth (L5) that is not greater than the thickness of the upper epitaxial layer (2), **characterised in that** the ion implantation process is to a concentration level of the implanted ions that is higher than 5 × 10¹⁸ cm⁻³, while after the end of the implantation, the mask (3) is removed and the epitaxial growth of the structure is finished, and afterwards at least one groove (7) for receiving an acidic etching medium is made in a protected external surface of said structure, with the groove reaching inside (L6) the structure at least up to a half of the thickness of the volumes that were subjected to the ion implantation and material (4) that was subjected to the ion implantation is removed by electrochemical etching with the acidic etching medium applied to the inside of the structure through said groove (7) wherein the upper epitaxial layer (2) is subjected to the ion implantation process with the use of germanium or silicon ions, wherein after the mask (3) is removed, the epitaxial growth of the structure is finished with a GaN layer (5) providing a flat upper surface of the structure, after which the epitaxial structure is annealed at a temperature ranging from 1000 to 1400 °C, for a period between ten seconds and one hour, and after annealing said structure, its upper surface is protected from the impact of the etching medium by covering with a covering layer (6) to form said protected external surface of said structure.

2. The method according to claim 1, **characterised in that** the mask (3) is made by a process of electron-beam lithography or photolithography.

3. The method according to claim 1 or 2, **characterised in that** the width (L2) of each of the windows (3') in the mask (3) ranges from 25 to 1750 nm, while the aggregate width (L1) of a window (3') and a spacing (3") adjoining said window ranges from 50 to 3000 nm.

4. The method according to claim 1 or 2 or 3, **characterised in that** oxalic acid and voltage ranging from 2 to 15 V are used for said electrochemical etching.

5. The method according to claim 1 or 2 or 3 or 4, **characterised in that** said electrochemical etching is carried out until empty air channels (8) are formed as a result of said electrochemical etching each having a length (L7) that is at least equal to a width of a mesa of an optoelectronic device in which the fabricated region with the regularly variable refractive index is intended to be used.

## Patentansprüche

1. Verfahren zur Herstellung eines Bereichs mit einem regelmäßig variablen Brechungsindex in einer ausgewählten Schicht einer epitaktisch auf einem kristallinen Substrat (1) hergestellten Halbleiterstruktur aus einer Gruppe-III-Nitrid beschichtet, wobei nach der Herstellung der ausgewählten Epitaxieschicht (2) der Wachstumsprozess unterbrochen wird und eine Maske (3), die eine Ionenimplantation lokal blockiert, auf die Oberseite der hergestellten Struktur (1, 2) aufgebracht wird, wobei die Maske (3) eine Anordnung von Längsfenstern (3') mit jeweils gleicher Breite (L2) enthält, die parallel zueinander und in gleichen Abständen (L3) verteilt sind, und anschließend die ausgewählte Epitaxieschicht, die die obere Epitaxieschicht (2) ist, einem Ionenimplantationsprozess bis zu einer Tiefe (L5) unterzogen wird, die nicht größer ist als die Dicke der oberen Epitaxieschicht (2), **dadurch gekennzeichnet, dass** der Ionenimplantationsprozess bis zu einem Konzentrationsgrad der implantierten Ionen erfolgt, der höher ist als 5 x 10¹⁸ cm⁻³, während nach dem Ende der Implantation die Maske (3) entfernt wird und das Epitaxiewachstum der Struktur beendet ist, und anschließend mindestens eine Nut (7) zur Aufnahme eines sauren Ätzmediums in einer geschützten Außenfläche der Struktur hergestellt wird, wobei die Nut mindestens bis zur Hälfte der Dicke der Volumina, die der Ionenimplantation unterzogen wurden, in die Struktur hineinreicht (L6) und das Material (4) entfernt wird, das der Ionenimplantation unterzogen wurde, durch elektrochemisches Ätzen mit dem sauren Ätzmedium, das durch die Nut (7) auf die Innenseite der Struktur aufgebracht wird, wobei die obere Epitaxieschicht (2) dem Ionenimplantationsprozess unter Verwendung von Germanium- oder Siliziumionen unterzogen wird, wobei nach dem Entfernen der Maske (3) das Epitaxiewachstum der Struktur mit einer GaN-Schicht (5) beendet wird, die eine flache Oberseite der Struktur bereitstellt, woraufhin die Epitaxiestruktur bei einer Temperatur im Bereich von 1000 bis 1400 °C für einen Zeitraum zwischen zehn Sekunden und einer Stunde getempert wird, und nach dem Tempern der Struktur wird deren Oberseite durch Abdecken mit einer Deckschicht (6) vor dem Aufprall des Ätzmediums geschützt, um die geschützte Außenfläche der Struktur zu bilden.

2. Verfahren nach Anspruch 1, **dadurch gekennzeichnet, dass** die Maske (3) durch ein Verfahren der Elektronenstrahllithografie oder Fotolithografie hergestellt wird.

3. Verfahren nach Anspruch 1 oder 2, **dadurch gekennzeichnet, dass** die Breite (L2) jedes der Fenster (3') in der Maske (3) zwischen 25 und 1750 nm liegt, während die Gesamtbreite (L1) eines Fensters (3') und eines an dieses Fenster angrenzenden Abstands (3") zwischen 50 und 3000 nm liegt.

4. Verfahren nach Anspruch 1 oder 2 oder 3, **dadurch gekennzeichnet, dass** Oxalsäure und eine Spannung im Bereich von 2 bis 15 V für das elektrochemische Ätzen verwendet werden.

5. Verfahren nach Anspruch 1 oder 2 oder 3 oder 4, **dadurch gekennzeichnet, dass** das elektrochemische Ätzen so lange durchgeführt wird, bis durch das elektrochemische Ätzen leere Luftkanäle (8) entstehen, die jeweils eine Länge (L7) aufweisen, die mindestens gleich einer Breite einer Mesa einer optoelektronischen Vorrichtung ist, in der der hergestellte Bereich mit dem regelmäßig variablen Brechungsindex verwendet werden soll.

## Revendications

1. Procédé de fabrication d'une région à indice de réfraction régulièrement variable dans une couche sélectionnée d'une structure semi-conductrice en couches de nitrure du groupe III fabriquée épitaxialement sur un substrat cristallin (1), après la fabrication de la couche épitaxiale sélectionnée (2), le processus de croissance est interrompu et un masque (3) qui bloque localement l'implantation ionique est appliqué sur la surface supérieure de la structure fabriquée (1, 2), dans lequel ledit masque (3) contient un ensemble de fenêtres longitudinales (3') ayant chacune la même largeur (L2), qui sont parallèles les unes aux autres et distribuées à un espacement égal (L3), et ensuite, la couche épitaxiale sélectionnée qui est la couche épitaxiale supérieure (2) est soumise à un processus d'implantation ionique à une profondeur (L5) qui n'est pas supérieure à l'épaisseur de la couche épitaxiale supérieure (2), **caractérisé en ce que** le processus d'implantation ionique se fait à un niveau de concentration des ions implantés supérieur à 5 x 10¹⁸ cm-3, alors qu'après la fin de l'implantation, le masque (3) est enlevé et la croissance épitaxiale de la structure est terminée, puis au moins une rainure (7) destinée à recevoir un milieu de gravure acide est pratiquée dans une surface externe protégée de ladite structure, la rainure atteint l'intérieur (L6) de la structure au moins jusqu'à la moitié de l'épaisseur des volumes qui ont été soumis à l'implantation ionique et le matériau (4) qui a été soumis à l'implantation ionique est enlevé par attaque électrochimique avec le milieu d'attaque acide appliqué à l'intérieur de la structure à travers ladite rainure (7) dans laquelle la couche épitaxiale supérieure (2) est soumise au processus d'implantation ionique avec l'utilisation d'ions de germanium ou de silicium, dans lequel, après l'élimination du masque (3), la croissance épitaxiale de la structure est terminée par une couche de GaN (5) fournissant une surface supérieure plane de la structure, après quoi la structure épitaxiale est recuite à une température comprise entre 1 000 et 1 400°C, pendant une période allant de dix secondes à une heure, et après le recuit de ladite structure, sa surface supérieure est protégée de l'impact du milieu de gravure en la recouvrant d'une couche de recouvrement (6) pour former ladite surface externe protégée.

2. Procédé selon la revendication 1, **caractérisé en ce que** le masque (3) est réalisé par un procédé de lithographie par faisceau d'électrons ou de photolithographie.

3. Procédé selon la revendication 1 ou 2, **caractérisé en ce que** la largeur (L2) de chacune des fenêtres (3') du masque (3) va de 25 à 1 750 nm, tandis que la largeur agrégée (L1) d'une fenêtre (3') et d'un espacement (3 ») adjacent à cette fenêtre va de 50 à 3000 nm.

4. Procédé selon la revendication 1, 2 ou 3, **caractérisé par** l'utilisation d'acide oxalique et d'une tension de 2 à 15 V pour la gravure électrochimique.

5. Procédé selon la revendication 1 ou 2 ou 3 ou 4, **caractérisé en ce que** ladite gravure électrochimique est effectuée jusqu'à ce que des canaux d'air vides (8) soient formés à la suite de ladite gravure électrochimique, chacun ayant une longueur (L7) au moins égale à la largeur d'une mésa d'un dispositif optoélectronique dans lequel la région fabriquée à indice de réfraction régulièrement variable est destinée à être utilisée.
